# DEMANDE DE BREVET EUROPEEN

(11) **EP 4 686 377 A1**
(43) Date de publication de la demande: **28.01.2026**
(21) Numéro de dépôt: 25188165.2
(22) Date de dépôt: 08.07.2025
(51) Int. Cl.: H10W 40/22, H10W 40/70, H10W 40/77

(54) **BOITIER DE CIRCUIT INTEGRE**

(30) Priorité: 19.07.2024 FR 2407995
(71) Demandeur: STMicroelectronics International N.V., 1228 Plan-les-Ouates, Geneva (CH)
(72) Inventeur: HAJJI, Asma, 38500 VOIRON (FR); HAJJI, Ouafa, 38500 VOIRON (FR); QUERCIA, Fabien, 38160 SAINT MARCELLIN (FR); BOUTALEB, Younes, 38100 GRENOBLE (FR)
(74) Mandataire: Cabinet Beaumont

(57) **Abrégé**

La présente description concerne un procédé de fabrication d'un dispositif électronique (1000) comprenant les étapes suivantes :
a) fournir un ensemble comprenant une puce (100) assemblée sur un substrat d'interconnexion (200),
b) déposer une couche de dissipation thermique (500) en un matériau d'interface thermique sur la puce (100),
c) fixer un capot (300) au substrat (200), le capot (300) recouvrant la puce (100), la couche de dissipation thermique (500) étant en contact avec le capot (300),
le procédé comprenant, en outre une étape d) au cours de laquelle un élément (400) en un matériau adhésif ou un matériau brasable est formé sur la puce (100), avant l'étape b), ou sur le capot (300), avant l'étape c), de manière à ce que, lors de l'étape c), l'élément (400) soit en contact avec le capot (300) et avec la puce (100) et positionné à côté de la couche de dissipation thermique (400).

## Description

### Domaine technique

La présente description concerne de façon générale les composants électroniques et, plus particulièrement, les boîtiers de circuit intégré, par exemple les boîtiers de type matrice de billes (ou BGA pour "Ball Grid Array") et le montage de puces électroniques dans ces boîtiers.

### Technique antérieure

Les boîtiers de type BGA permettent d'intégrer électriquement une puce électronique à un élément extérieur comme, par exemple à un circuit imprimé (ou PCB pour "Printed Circuit Board").

Avec la miniaturisation des composants électroniques, la gestion de la dissipation thermique devient de plus en plus critique. Pour améliorer les performances thermiques des composants électroniques, les boîtiers comprennent un capot (ou couvercle) thermiquement conducteur positionné au-dessus de la puce et fixé au substrat. Le capot permet de participer à la dissipation de la chaleur produite par la puce.

La présence d'un matériau d'interface thermique (TIM) positionné sur la puce et en contact avec le couvercle peut faciliter la dissipation thermique.

### Résumé de l'invention

Il existe un besoin d'amélioration des boîtiers pour puces électroniques, et notamment un besoin d'améliorer la dissipation thermique de ces boîtiers.

Ce but est atteint par un procédé de fabrication d'un dispositif électronique comprenant les étapes suivantes :
a) fournir un ensemble comprenant une puce et un substrat d'interconnexion, la puce ayant une première face et une deuxième face, la première face de la puce étant assemblée sur le substrat d'interconnexion par des plots de contact,
b) déposer une couche de dissipation thermique en un matériau d'interface thermique sur la deuxième face de la puce,
c) fixer un capot au substrat, le capot recouvrant la puce, la couche de dissipation thermique étant en contact avec le capot,
le procédé comprenant, en outre, une étape d) au cours de laquelle un élément en un matériau adhésif ou en un matériau brasable est formé soit sur la puce, avant l'étape b), soit sur le capot, avant l'étape c), de façon à ce que, lors de l'étape c), l'élément soit en contact avec le capot et avec la puce et soit positionné à côté de la couche de dissipation thermique.

Selon un mode de réalisation particulier, l'élément est en un matériau polymère B-stage.

Selon un mode de réalisation particulier, lors de l'étape d), le matériau polymère B-stage est déposé puis pré-polymérisé, et, lors de l'étape c) ou après l'étape c), le matériau B-stage est polymérisé.

Selon un mode de réalisation particulier, l'élément est en un matériau d'interface thermique, identique ou différent du matériau d'interface thermique de la couche de dissipation thermique.

Selon un mode de réalisation particulier, l'élément est en un matériau brasable, l'élément étant soudé par ultrasons à l'un du capot ou de la deuxième face de la puce lors de l'étape d) et à l'autre du capot ou de la deuxième face de la puce lors de l'étape c) ou après l'étape c).

Ce but est également atteint par un dispositif électronique comprenant une puce électronique disposée entre un substrat d'interconnexion et un capot, une première face de la puce électronique comprenant des plots de contact fixées au substrat d'interconnexion, une couche de dissipation thermique et un élément en un matériau adhésif ou en un matériau brasable étant positionnés sur une deuxième face de la puce et en contact avec le capot.

Selon un mode de réalisation particulier, l'élément est en un matériau polymère B-stage, de préférence choisi parmi les polyépoxydes.

Selon un mode de réalisation particulier, l'élément est en un matériau d'interface thermique, identique ou différent du matériau d'interface thermique de la couche de dissipation thermique.

Selon un mode de réalisation particulier, l'élément forme des bandes ou des plots, positionné(e)s autour de la couche de dissipation thermique.

Selon un mode de réalisation particulier, le capot est un capot métallique, de préférence en cuivre.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, la figure 2, la figure 3 et la figure 4 représentent, de manière schématique différentes étapes d'un procédé de fabrication d'un boîtier de circuits intégrés, selon un mode de réalisation particulier ;
la figure 5 représente, de manière schématique une variante d'une étape d'un procédé de fabrication d'un boîtier de circuits intégrés, selon un autre mode de réalisation particulier ;
la figure 6A, la figure 6B, la figure 6C et la figure 6D, représentent, de manière schématique et en vue de dessus, une puce, sur un substrat, recouverte localement par un élément adhésif ou par un élément brasable, selon un autre mode de réalisation particulier ; et
la figure 7 représente, de manière schématique et en coupe, un boîtier de circuits intégrés selon un mode de réalisation particulier.

Dans les différentes figures, les différents éléments et composants ne sont pas nécessairement représentés à la même échelle les uns par rapport aux autres.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas" , "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Par compris entre X et Y, on entend que les bornes X et Y sont incluses, ce qui est équivalent à au moins X et jusqu'à Y.

Par matériau polymère B-stage, on entend un matériau polymère à étapes multiples de polymérisation. Le matériau polymère final est formé de façon séquentielle par un procédé de polymérisation en plusieurs étapes. Une première étape de polymérisation conduit à l'obtention d'un matériau pré-polymérisé (i.e. partiellement polymérisé). Le matériau pré-polymérisé présente un premier degré de polymérisation. Il est à un stade A de polymérisation. Cette première étape permet de 'figer' le matériau tout en lui laissant une certaine adhésivité. Une seconde et dernière étape de polymérisation conduit à l'obtention d'un matériau polymérisé, de préférence complètement polymérisé (stade B de polymérisation). Le degré de polymérisation du stade B est supérieur au premier degré de polymérisation du stade A. Le matériau polymérisé est rigide et adhère aux éléments avec lesquels il est en contact.

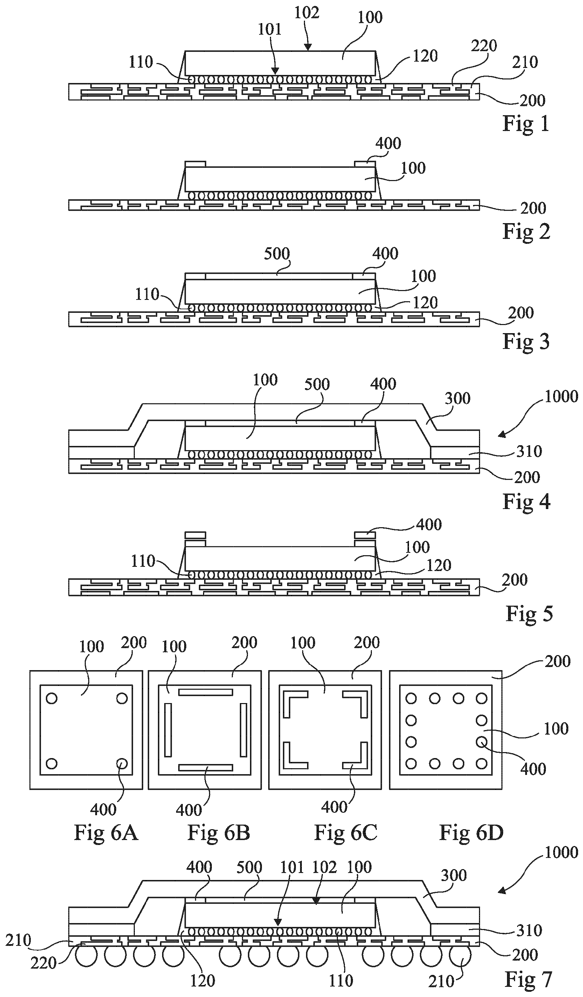

Nous allons maintenant décrire le procédé de fabrication d'un boîtier pour circuits intégrés en faisant référence aux figures 1 à 4.

Le procédé comprend les étapes suivantes :
a) fournir un ensemble comprenant une puce 100 ayant une première face 101 et une deuxième face 102, la première face 101 de la puce 100 étant assemblée à un substrat 200 par l'intermédiaire de plots de connexion 110 (figure 1),
b) déposer une couche 500 de dissipation thermique en un matériau d'interface thermique sur la deuxième face 102 de la puce 100 (figure 3),
c) fixer un capot 300 au substrat 200, le capot 300 recouvrant la puce 100, la couche de dissipation thermique 500 étant en contact avec le capot 300, la capot 300 et le substrat d'interconnexion 200 formant le boîtier de la puce (figure 4).

Le procédé comprend, en outre, avant l'étape c), une étape d) au cours de laquelle un élément 400 en un matériau adhésif ou brasable est formé sur le capot 300 ou la deuxième face 102 de la puce 100 (figure 2). Le positionnement de l'élément est choisi de manière à ce que, lors de l'étape c), l'élément 400 soit positionné à côté de la couche de dissipation 500 et qu'ils ne se chevauchent pas. La couche de dissipation 500 est positionnée sur une première partie de la deuxième face 102 de la puce 100. L'élément 400 est positionné sur une deuxième partie de la deuxième face 102 de la puce 100. La première partie correspond, de préférence, à la zone centrale de la deuxième face 102 et la deuxième partie correspond, de préférence, à la zone périphérique de la deuxième face 102. L'élément 400 et la couche de dissipation 500 peuvent être disposés de manière adjacente ou séparés par un espace.

Selon une première variante de réalisation, l'élément 400 est formé sur la deuxième face 102 de la puce 100. De préférence, cette étape est réalisée entre l'étape a) et l'étape b). L'élément 400 permet de contenir, partiellement ou totalement, la couche de dissipation 500 lors de sa formation (étape b)).

Selon une deuxième variante de réalisation, l'élément 400 est formé sur le capot 300 de manière à ce que, lors de l'étape c), l'élément 400 recouvre une deuxième partie de la deuxième face 102 de la puce 100.

La mise en œuvre de l'étape d) permet de positionner l'élément 400 qui joue le rôle de cale entre le capot 300 et la puce 100 et permet de positionner correctement le capot 300 à la hauteur désirée par rapport à la puce 100.

De plus, avec un tel procédé, l'uniformité (épaisseur et surface couverte) de la couche de dissipation 500 est contrôlée. Le dispositif électronique 1000 obtenu présente une très bonne dissipation thermique. L'épaisseur de la ligne liaison (BLT pour 'Bond Line Thickness') est facilement contrôlée en ajustant l'épaisseur de l'élément 400.

De plus, une excellente adhérence entre la couche de dissipation 500 et le capot 300 est obtenue. Le dispositif a une meilleure tenue mécanique, ce qui évite les problèmes de délamination. La durée de vie ainsi que les performances du composant sont améliorées.

Nous allons maintenant décrire plus en détail les différentes étapes de ce procédé et les différents éléments utilisés pour obtenir le dispositif électronique 1000.

L'ensemble fourni à l'étape a) comprend une puce 100 assemblée sur un substrat d'interconnexion 300 au moyen de plots de contact 110.

La puce 100 comprend une première face principale 101 (face inférieure) et une deuxième face principale 102 (face supérieure) .

La première face principale 101 est disposée en regard du substrat d'interconnexion 200.

La puce 100 peut comprendre un substrat, dans et/ou sur lequel sont formés des circuits intégrés et/ou des éléments électroniques discrets, comme des transistors, et un empilement d'interconnexion formé d'un empilement de couches isolantes et conductrices situé du côté de la première face 101 de la puce 100. Par exemple, le substrat est un substrat semiconducteur, notamment en silicium. Ces différents éléments/différentes parties ne sont pas représentées sur les figures pour une meilleure lisibilité.

La puce 100 est une puce dite retournée ('flip-chip'), c'est-à-dire que la partie active de la puce 100 est disposée en regard du substrat d'interconnexion 200.

Les plots de contact 110 sont disposés sur la face inférieure 101 de la puce 100, du côté de l'empilement d'interconnexion.

La connexion entre la puce 100 et le substrat d'interconnexion 200 s'effectue par l'intermédiaire des plots de contacts 110 de la puce. La puce 100 peut comprendre plusieurs plots de contact 110. La puce 100 peut comprendre au moins une dizaine de plots de contact 110, par exemple, au moins une centaine de plots de contacts 110. A titre d'exemple, les plots de contact 110 sont régulièrement répartis sur la face inférieure 101 de la puce 100. Ils peuvent être agencés en réseau matriciel.

Les plots de contact 110 sont en un matériau conducteur électriquement. Par exemple, les plots de contact 110 sont en un matériau brasable. Les plots de contact 110 sont, par exemple, en cuivre, en argent ou en étain, ou en un alliage, par exemple à base d'étain et d'argent (SnAg).

Une couche de polymère 120 électriquement isolant ('underfill') est positionnée, sous la puce 100, entre le substrat d'interconnexion 200 et la puce 100. La couche de polymère 120 enrobe les plots de connexion 110 de la puce. Cette couche 120 permet de protéger l'intégrité mécanique des plots 110 et les protège de l'oxydation. Cette couche 120 d'enrobage est, par exemple, une couche en époxy. Elle est injectée après le report de la puce 100 sur le substrat 200 par capillarité.

Le substrat d'interconnexion 200 permet d'assembler la puce 100 à un dispositif extérieur selon une technique dite de montage en surface.

Le substrat 200 peut avoir, en vue de dessus, une forme sensiblement carrée ou rectangulaire. A titre d'exemple, le substrat 200 est, en vue de dessus, plus grand que la puce 100. Le substrat 200 peut avoir des dimensions en vue de dessus, supérieures à 10 mm par 10 mm et inférieures à 110 mm par 110 mm, par exemple de l'ordre de 25 mm par 25 mm.

Le substrat 200 comprend, par exemple, un empilement de différentes couches isolantes 210 et de différentes couches métalliques 220 pour former des interconnexions entre les deux faces principales du substrat 200. Le substrat 200 peut comprendre, par exemple, des pistes métalliques horizontales dans l'orientation de la figure 1 et/ou des vias métalliques verticaux dans l'orientation de la figure 1.

Sur les différentes figures et dans les différents modes de réalisation, une seule puce 100 est représentée entre le substrat 200 et le capot 300. Cependant, il est possible d'avoir plusieurs puces entre le substrat 200 et le capot 300.

Des dispositifs électroniques passifs supplémentaires non représentés, tels que, par exemple, des résistances, des inductances et des condensateurs, peuvent être montés sur le substrat 200 autour de la puce 100.

Lors de l'étape b), on dépose une couche de dissipation 500 en matériau d'interface thermique (ou TIM pour 'thermal interface material') sur une première partie de la deuxième face 102 de la puce 100. De préférence, il s'agit de la partie centrale de la deuxième face 102 de la puce 100.

La couche 500 présente par exemple une conductivité thermique supérieure à celle de l'air. La couche 500 est par exemple une couche de pâte, de graisse ou de colle thermique.

Le matériau TIM est, par exemple, un composite comprenant un polymère, tel qu'un polysiloxane (ou silicone), et des charges thermiquement conductrices. Les charges sont, par exemple, des particules d'argent.

Un matériau TIM est, par exemple, commercialisé par la société Wacker.

Le matériau peut être également déposé sous forme de serpentins, sous forme de 'X' ou sous tout autre forme adaptée. Lors du positionnement du capot 300, le matériau déposé s'étalera sous forme d'une couche. Plus la surface de contact, d'une part, entre la puce 100 et le matériau TIM, et, d'autre part, entre le capot 300 et le matériau TIM sera élevée et plus la dissipation thermique sera améliorée.

La couche 500 de dissipation thermique permet de dissiper la chaleur produite par la puce 100 lors de son fonctionnement vers le capot métallique 300 et donc vers l'extérieur du dispositif 1000.

Le procédé comprend une étape d) au cours de laquelle un élément 400 en un matériau adhésif ou brasable est positionné soit sur le capot 300 soit sur la puce 100.

Selon une première variante de réalisation, l'élément 400 est positionné sur la puce 100, et plus particulièrement, sur la deuxième face 102 de la puce 100.

Selon cette première variante, l'étape d) est, de préférence, réalisée avant l'étape b). L'élément 400 peut jouer le rôle de barrière lors de la formation de la couche de dissipation 500 et éviter que le matériau TIM ne coule/flue hors de la deuxième face 102 de la puce 100.

Selon une deuxième variante de réalisation, l'élément 400 est positionné sur le capot 300. Il est positionné de manière à ce que, une fois le capot 300 assemblé sur la puce 100, il soit positionné sur une deuxième partie de la deuxième face 102 de la puce. Autrement dit, il sera positionné de manière adjacente à la couche de dissipation 500.

Selon cette deuxième variante, l'étape d) peut être réalisée avant ou après l'étape b).

Selon un mode de réalisation particulier, l'élément 400 est en un matériau brasable, notamment en métal ou en un alliage de métal. Il est, de préférence, en or ou en cuivre. Il sera par exemple soudé sur le capot 300 et/ou sur la puce 100, de préférence par soudage par ultrasons. Une couche d'accroche (non représentée) peut être préalablement déposée sur le capot 300 et/ou sur la deuxième face 102 de la puce 100 afin de rendre la surface du capot 300 et/ou de la puce 100 compatible avec un brasage et/ou favoriser la tenue mécanique de l'élément sur le capot 300 et/ou sur la puce 100. La couche d'accroche est, par exemple, une couche en or.

Selon un autre mode de réalisation particulier, l'élément 400 est un matériau adhésif. Il s'agit d'un polymère ou d'un composite comprenant au moins un polymère dans lequel peuvent être dispersées des charges.

Le matériau adhésif est, par exemple, un polymère B-stage. Le polymère B-stage est, de préférence, un époxy (aussi appelé polyépoxide) ou un (méth)acrylate. Une fois appliqué sur le capot 300 ou sur la puce 100, une première étape de traitement thermique et/ou de traitement UV (éventuellement suivi d'un recuit) permet de pré-polymériser le matériau. Il acquiert ainsi une certaine rigidité et une certaine adhésion. Il est ainsi non seulement solidaire du capot 300 ou de la puce 100 mais également rigide, et peut servir de cale entre le capot 300 et la puce 100. Une fois le capot 300 positionné sur le substrat 100, une seconde étape de polymérisation au moyen d'un traitement thermique et/ou d'un traitement UV (éventuellement suivi d'un recuit) permet de terminer la polymérisation du matériau B-stage. Cette étape peut être réalisée simultanément à l'étape c) ou ultérieurement à l'étape c). Le capot 300 adhère ainsi à la puce 100. Par exemple, la première étape est un traitement thermique à une température comprise entre 100 et 125°C et la seconde étape est un traitement thermique à une température de 150°C.

Le matériau B-Stage est, par exemple, commercialisé par la société Loctite, Delo, Henkel ou Sumimoto.

Alternativement, le matériau adhésif est un matériau TIM. Le matériau TIM peut être identique ou différent du matériau TIM de la couche de dissipation 500. De préférence, il est différent. Une fois appliqué, une étape de traitement thermique ou de traitement UV permet de polymériser le matériau. Il acquiert ainsi une certaine rigidité et une certaine adhésion. Il est ainsi non seulement solidaire du capot 300 ou de la puce 100 mais également rigide, et peut servir de cale.

Le matériau adhésif (B-stage ou TIM) peut être déposé par jet ('jetting') ou par dispense.

L'élément 400 (adhésif ou brasable) peut être déposé en une ou plusieurs fois. Par exemple, sur la figure 5, deux couches sont déposées pour former l'élément 400. Le nombre de couches déposées dépend, notamment, de l'épaisseur souhaitée. Dans le cas d'un élément adhésif en B-stage, il est possible de réaliser un traitement UV ou un traitement entre chaque dépôt de couche, ou à l'issue du dépôt des différentes couches, afin de le pré-polymériser.

L'élément 400 peut être continu ou discontinu. Il peut former un cordon continu qui entourera la couche 500 de TIM lors de l'étape b) ou c). De préférence, l'élément 400 est discontinu (figures 6A, 6B, 6C et 6D) pour faciliter le dégazage du matériau de la couche de dissipation 500. L'élément 400 être sous la forme de plots (figures 6A et 6D), de cordons ou bandes, par exemple linéaires (figure 6B) ou en forme de L (figures 6C). Les différentes parties de l'élément 400 peuvent être positionnées sur les bords et/ou dans les coins de la deuxième face 102 de la puce 100.

Lors de l'étape c), le capot 300 (aussi appelé couvercle) est fixé sur le substrat 200. Le capot 300 comprend une partie supérieure plane et des parties latérales. La partie inférieure du capot forme un rebord destiné à être fixé au substrat 200. Une fois positionné sur le substrat 200, le capot 300 forme une cavité permettant de contenir une ou plusieurs puces 100. La face interne du capot 300 délimite en partie la cavité. La face externe du capot est orientée vers l'extérieur.

Le capot 300 permet notamment de dissiper la chaleur accumulée dans la puce électronique 100.

A titre d'exemple, le capot 300 a, en vue de dessus, une forme similaire à la forme du substrat 200. Il peut avoir une forme sensiblement carrée ou rectangulaire. Les dimensions latérales du capot 300 sont, par exemple, sensiblement identiques aux dimensions latérales du substrat 200. Le capot 300 est, par exemple, fixé au substrat 200 à l'aide d'une couche de colle 310. De préférence, le capot 300 est fixé au substrat 200 de façon localisée c'est-à-dire que la couche de colle 310 ne s'étend pas sur toute la périphérie du capot 300 et du substrat 200. En particulier, le capot 300 et le substrat 200 peuvent être fixés l'un à l'autre par l'intermédiaire de la couche de colle 310 seulement sur leurs quatre coins.

Le capot 300 peut être formé par emboutissage.

Le capot 300 est en un matériau thermiquement conducteur. De préférence, le capot 300 est un capot métallique. Il est, par exemple, en cuivre. Un placage, par exemple, en nickel peut recouvrir le capot 300.

Lors de l'étape c), le capot 300 est fixé :
- au substrat 200 grâce à une couche de colle 310 positionnée entre les rebords du capot 300 et le substrat 200, et
- à la puce grâce à la couche de dissipation 500 et grâce à l'élément 400 adhésif ou brasable.

Dans le cas où le matériau est un matériau adhésif, l'étape c) est réalisée, par exemple, selon les sous-étapes suivantes :
- positionner le capot 300 sur l'ensemble formé de la puce 100 et du substrat d'interconnexion 200,
- réaliser un traitement thermique et/ou une irradiation sous rayonnement ultra-violet pour polymériser le matériau adhésif.

La traitement thermique et/ou l'irradiation sous rayonnement ultra-violet peut permettre simultanément de polymériser la couche de colle 310 positionnée entre le capot 300 et le substrat 200.

Dans le cas où le matériau est un matériau brasable, l'étape c) comporte les sous-étapes suivantes :
- positionner le capot 300 sur l'ensemble formé de la puce 100 et du substrat d'interconnexion 200,
- réaliser une sous-étape de soudage, de préférence, un soudage aux ultra-sons pour souder le capot 300 à la puce 100,
- réaliser un traitement thermique et/ou une irradiation sous rayonnement ultra-violet pour polymériser la couche de colle 310 positionnée entre le capot 300 et le substrat 200.

L'ordre de ces deux dernières sous-étapes peut être inversé.

Une fois l'étape c) réalisée, on obtient un composant électronique 1000 pouvant être assemblé à un élément extérieur. Un tel composant 1000 est, par exemple, représenté sur la figure 7.

Le composant électronique 1000 comprend une puce 100 ayant une première face 101 et une deuxième face 102, la première face 101 de la puce 100 étant assemblée sur un substrat 200 par des plots de connexion 110. Un capot 300 en un matériau thermiquement conducteur est fixé au substrat 200, par exemple par une couche de colle 310, et recouvre la puce 100. Une couche de dissipation thermique 500 en un matériau d'interface thermique recouvre une première partie de la deuxième face 102 de la puce 100 et est en contact avec le capot 300.

Le capot est, en plus, fixé à une deuxième partie de la deuxième face 102 de la puce 100 au moyen d'un élément 400 en matériau adhésif ou en un matériau brasable.

Le capot 300 et le substrat d'interconnexion 200 forme un boîtier protégeant la puce 100 et permettant de la relier électriquement à un élément extérieur (non représenté sur les figures), par exemple un dispositif extérieur ou à un substrat de type PCB (carte de circuit imprimé ou 'printed circuit board'). Le substrat 200 peut être monté et connecté électriquement sur le dispositif extérieur, par exemple au moyen de plots d'interconnexion 210 positionnées sur la deuxième face du substrat 200 (figure 7).

Les plots d'interconnexion 210 peuvent être des billes, piliers ou des colonnes. Les billes 210 sont par exemple régulièrement réparties sur la face inférieure du substrat 200, par exemple selon un réseau matriciel. Les dimensions latérales des billes 210 et le pas inter-billes 210 sont par exemple supérieurs respectivement aux dimensions latérales des plots de contact 110 de la puce et au pas inter-plots 110 de la puce 100. Le substrat 200 réalise ainsi une fonction d'étalement et de redistribution des contacts de la puce 100 vers les contacts du dispositif extérieur.

De tels composants électroniques, aussi appelés composant TEFCBGA (pour 'thermally enhanced flip-chip ball grid array') sont particulièrement intéressants pour de nombreuses applications.

Ils permettent de réaliser un grand nombre d'I/O, avec des bonnes performances et une bonne dissipation thermique.

Le dispositif est, par exemple, destiné à l'industrie automobile. En particulier, le dispositif peut être utilisé dans un microcontrôleur ou dans un système avancé d'aide à la conduite (ADAS pour 'Advanced Driver Assistance Systems').

Il peut être utilisé dans les dispositifs de calcul intensif (HPC pour 'High-performance computing'), par exemple dans les unités centrales de traitement (CPU pour 'Central Processing Unit') ou dans les processeurs graphiques (GPU pour 'Graphics processing unit').

Le dispositif peut par exemple être utilisé dans le domaine industriel. Plus particulièrement, le dispositif vise par exemple à être utilisé pour le développement des énergies vertes ou pour l'électrification d'infrastructures, par exemple pour des bornes de recharge ou pour l'énergie solaire.

Le dispositif peut également être utilisé dans le domaine de l'internet des objets et des maisons intelligentes.

Le dispositif peut également être utilisé dans la mise en œuvre de réseaux 5G, de centres de données et de serveurs.

Le dispositif est, par exemple, destiné à être utilisé dans de l'électronique personnelle, par exemple dans le but d'augmenter le contenu radiofréquence, dans les dispositifs de connexions 5G ou plus généralement dans les dispositifs connectés. Le dispositif est par exemple utilisé dans des téléphones portables ('smartphone') ou pour les réseaux de l'internet des objets. Le dispositif est par exemple connecté par 5G ou WIFI. L'appareil comprend par exemple des interfaces à haut débit, par exemple avec un filtrage avancé et une protection contre les décharges électromagnétiques.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Procédé de fabrication d'un dispositif électronique (1000) comprenant les étapes suivantes :
a) fournir un ensemble comprenant une puce (100) et un substrat d'interconnexion (200), la puce ayant une première face (101) et une deuxième face (102), la première face (101) de la puce (100) étant assemblée sur le substrat d'interconnexion (200) par des plots de contact (110),
b) déposer une couche de dissipation thermique (500) en un matériau d'interface thermique sur la deuxième face (102) de la puce (100),
c) fixer un capot (300) au substrat (200), le capot (300) recouvrant la puce (100), la couche de dissipation thermique (500) étant en contact avec le capot (300), le capot (300) formant une cavité contenant la puce (100),
le procédé comprenant, en outre, une étape d) au cours de laquelle un élément (400) en un matériau polymère B-stage ou en un matériau brasable est formé soit sur la puce (100), avant l'étape b), soit sur le capot (300), avant l'étape c), de façon à ce que, lors de l'étape c), l'élément (400) soit en contact avec le capot (300) et avec la puce (100) et soit positionné à côté de la couche de dissipation thermique (500),
l'étape c) comprenant une sous-étape au cours de laquelle un soudage aux ultra-sons est mis en œuvre pour souder le capot (300) à la puce (100), ou
l'étape b) comprenant un premier traitement thermique et/ou un premier traitement UV pour pré-polymériser le matériau polymère B-stage et le procédé comprenant une étape additionnelle, durant l'étape c) ou après l'étape c), au cours de laquelle un deuxième traitement thermique et/ou un deuxième traitement UV est mis en œuvre pour polymériser le matériau polymère B-stage.

2. Procédé selon la revendication 1, dans lequel l'élément (400) est en un matériau polymère B-stage.

3. Procédé selon la revendication précédente, dans lequel, lors de l'étape d), le matériau polymère B-stage est déposé puis pré-polymérisé, et dans lequel, lors de l'étape c) ou après l'étape c), le matériau B-stage est polymérisé.

4. Procédé selon la revendication 1, dans lequel l'élément (400) est en un matériau d'interface thermique, identique ou différent du matériau d'interface thermique de la couche de dissipation thermique (500).

5. Procédé selon la revendication 1, dans lequel l'élément (400) est en un matériau brasable, l'élément (400) étant soudé par ultrasons à l'un du capot (300) ou de la deuxième face (102) de la puce (100) lors de l'étape d) et à l'autre du capot (300) ou de la deuxième face (102) de la puce (100) lors de l'étape c) ou après l'étape c).

6. Dispositif électronique comprenant une puce électronique (1000) disposée entre un substrat d'interconnexion (200) et un capot (300), le capot (300) formant une cavité contenant la puce (100), une première face (101) de la puce électronique (100) comprenant des plots de contact (110) fixées au substrat d'interconnexion (200), dans lequel une couche de dissipation thermique (500) et un élément (400) en un matériau polymère B-stage ou en un matériau brasable sont positionnés sur une deuxième face (102) de la puce et en contact avec le capot (300).

7. Dispositif selon la revendication 6, dans lequel l'élément (400) est en un matériau polymère B-stage, de préférence choisi parmi les polyépoxydes.

8. Dispositif selon la revendication 6, dans lequel l'élément (400) est en un matériau d'interface thermique, identique ou différent du matériau d'interface thermique de la couche de dissipation thermique (500).

9. Dispositif selon l'une des revendications 6 à 8, dans lequel l'élément (400) forme des bandes ou des plots, positionné(e)s autour de la couche de dissipation thermique (500).

10. Dispositif selon l'une des revendications 6 à 9, dans lequel le capot (300) est un capot métallique, de préférence en cuivre.
